Europäisches Patentamt

European Patent Office

Office européen des brevets

(19)

(11) Publication number: **0 206 145**
**B1**

# EUROPEAN PATENT SPECIFICATION

(12)

(45) Date of publication of the patent specification:
03.10.90

(51) Int. Cl.⁵: **C23C 14/02**, B29C 59/16,
C23C 14/20

(21) Application number: 86108025.7

(22) Date of filing: 12.06.86

(54) A method of metallising an organic substrate so as to achieve improved adhesion of the metal.

(30) Priority: 20.06.85 US 746908

(43) Date of publication of application:
30.12.86 Bulletin 86/52

(45) Publication of the grant of the patent:
03.10.90 Bulletin 90/40

(84) Designated Contracting States:
DE FR GB IT

(56) References cited:
FR-A- 1 182 284
FR-A- 1 547 700
GB-A- 1 083 778
GB-A- 2 071 673
US-A- 3 069 286

IBM TECHNICAL DISCLOSURE BULLETIN, vol. 26,
no. 7A, December 1983, page 3429, IBM, New York, US;
M.S. COHEN et al.: "Process for initiating the
deposition of magnesium and other low melting-point
metals onto polymeric substrates"
PATENT ABSTRACTS OF JAPAN, vol. 9,
no. 211 (C-300)[1934], 29th August 1985

(73) Proprietor: International Business Machines
Corporation, Old Orchard Road, Armonk, N.Y. 10504(US)

(72) Inventor: Clabes, Joachim Gerhard, 2854 Hickory Street,
Yorktown Heights New York 10598(US)
Inventor: Hahn, Peter Otto, Schopenhauerweg 5,
D-8263 Burghausen(DE)
Inventor: Ho, Paul Siu-Chung, 5 Whippoorwill Lake
Road, Chappaqua New York 10514(US)
Inventor: Lefakis, Haralambos Nmn, 7205 Saratoga
Apartment V105, San Jose California 95129(US)
Inventor: Rubloff, Gary Wayne, 16 Nightingale Road,
Katonah New York 10536(US)

(74) Representative: Hobbs, Francis John, IBM United
Kingdom Limited Intellectual Property Department
Hursley Park, Winchester Hampshire SO21 2JN(GB)

EP 0 206 145 B1

## Description

This invention relates to a method of metallising an organic substrate so as to achieve improved adhesion of the metal to the substrate.

The metallisation of organic substrates, such as plastics materials, is becoming increasingly important, especially in the electronics field. Most packaging approaches require metallisation to be applied to organic (polymer) substrates, for example, copper on polyimide. In the prior art, copper has been deposited by a number of techniques, including plating, vacuum evaporation, and sputtering. Often, chemical conditioning of the substrate surface is utilised prior to deposition in order to obtain better adherence of the metal film to the substrate. However, poor adhesion between the metal and the organic substrate is a major problem.

Many approaches have been tried to enhance adhesion between metal films and organic substrates, with varying degrees of success. In some situations, metals are matched with particular resinous substrates where it has been determined that adherence therebetween is superior to other metal-substrate combinations. Still other situations use extensive pre-cleaning of the substrates prior to metal deposition in order to remove contaminants and roughen the substrate surface. In many of these methods, expensive and/or toxic chemical substances are employed, which is a further disadvantage.

Other techniques utilise glow discharges or plasma discharges to affect the polymer surface prior to metal deposition. Examples of the use of a glow discharge to enhance adhesion are found in US-A-4,165,394 and 4,250,225. This type of technique is also described by L R Yetter in IBM Technical Disclosure Bulletin, Vol 16, No 7, page 2845, December 1973. In glow discharge techniques, a brush or glow discharge is created by introducing residual gases into a vacuum chamber and applying a high voltage in order to create ions which activate the polymer substrate surface. Examples of the gases which can be introduced into the vacuum chamber include air, oxygen, nitrogen, helium, neon, argon, krypton, xenon, and radon. After the glow discharge activation, the metal film is deposited by techniques such as electroless plating, vacuum deposition and sputtering.

Another technique for enhancing adhesion between metal films and organic substrates is plasma treatment of the substrates. This technique is very similar to the aforementioned glow discharge technique and is described in, for example US-A-4,337,279 and US-A-4,382,101. It is also described in an abstract of Japanese patent J55099932. In this technique, the organic substrate is placed in a plasma reactor, where the plasma is produced by the introduction of a gas such as helium, argon, $CF_4$, $C_3F_8$, $C_4F_8$, $CHF_3$, carbon fluoride, nitrogen or oxygen. Plasma treatment of the substrate occurs for varying periods of time measured from minutes to several hours.

Another treatment process for enhancing metal-organic substrate deposition is the use of high energy ion beams. Examples of this technique are described by J E Griffith et al, Nuclear Instr and Methods, 198, 608 (1982) and in papers presented by J Baglin et al at the Materials Research Society Meeting, Boston, Mass, November 14 to 17 1983. In ion beam enhanced adhesion, a high energy beam of ions is incident upon the organic substrate prior to deposition of a metal layer. For example, copper can be deposited on polymer substrates by electron beam deposition, after high energy ion irradiation of the substrates. In this procedure, both reactive and inactive ions can be used, and the ion beam energy ranges upwards from about 200 keV.

While some degree of success had been recorded for these techniques to enhance adhesion, each such technique is not without difficulties. For example, plasma and glow discharge techniques offer very poor control, of ion energy and current, ambient gas pressure, substrate temperature, etc. Also, it is very difficult to obtain good control of the energy beam flux in plasma and glow discharge systems. These systems require high pressures, of the order of 133 Pascals (1 torr) which corresponds to $1 \times 10^{21}$ gas atoms/cm²-sec, in order to maintain the discharge. These rates also cannot be readily matched with metal evaporation rates, and evaporation cannot be carried out at such high pressures. This in turn means that metal deposition has to be by plasma sputtering, rather than any other technique. Further, in plasma and glow discharge systems, there is very poor control over the incident ion beam direction as the ions strike the substrate surface. It is also the situation that the purity of residual gas control in such systems is not well controlled and is often sufficiently high that contamination can easily occur.

High energy ion beam enhancement of adhesion is also not without problems. Such systems are costly and require complicated apparatus to produce the high energy, focussed ion beam. The nature of the ion beam makes it impossible to be able to process large substrate areas simultaneously, and therefore is not readily suitable for high throughput in commercial systems. Further, high energy ion beams can cause damage to the organic substrate and require large amounts of power. It is also extremely difficult to make large, high energy ion beams with the proper flux and power over a large area.

Wet processing steps, such as chemical steps, are also difficult to control and often require toxic or otherwise offensive solutions. When chemical cleaning is used, there is always a later exposure of the substrates to the environment, and therefore possible contamination can occur. In general, it is preferable to have a completely dry processing system for both surface preparation and metal deposition.

This invention seeks to provide a simple technique for obtaining improved metal organic substrate adhesion, and which is suitable for use in commercial manufacturing processes.

The invention provides a method of metallising an organic substrate so as to achieve improved adhe-

2

sion of the metal, comprising irradiating a surface of the substrate with low energy particles, said particles being either:

(a) reactive ions or electrons having energies in the range of about 50 to 2000 eV, or
(b) photons having energies in the range of about 0.2 to 500 eV,

the surface being subjected to said irradiation until the chemical composition of the substrate is altered due to said irradiation to a depth of approximately 1 to 30 nm from said surface, and depositing metal onto the irradiated surface at an initial rate of approximately 0.1 to 10 nm per sec.

This technique for enhancing metal-organic substrate adhesion uses low energy reactive ion, electron, or photon irradiation of the organic substrate in order to alter the surface chemistry of the substrate to a depth from about 1 nm to 30 nanometers, so that enhanced adhesion between the metal and the substrate will occur. The energy of the irradiated particles is about 50 to 2000 eV and preferably about 200 to 500 eV. In this technique, the dominant mechanism for adhesion is an alteration of the surface chemistry of the substrate, rather than a rearrangement of the surface atoms and molecules. For this reason, it is distinguished from the high energy ion beam techniques described hereinabove, which physically alter the atomic arrangement in the surface of the substrate. In further distinction with the high ion beam energy techniques of the prior art, the present invention will not work with inert ions. Still further, the present invention can use electrons and photons as incident particles. Since these particles have negligible mass, momentum transfer is not the dominant mechanism for the changes which occur; instead these particles are used to alter the surface chemistry. This further distinguishes the present technique from the prior art high energy ion bombardment techniques wherein momentum transfer is a dominant mechanism.

The low energy particle irradiation can occur prior to metal deposition, or simultaneously with metal deposition. If particle irradiation occurs simultaneously with metal deposition, the arrival rates of the metal atoms and the particles are adjusted to be comparable, at least within about 2 orders of magnitude of each other. Only by controlled energy beam irradiation can the relative impingement rate of the energy beam and the metal atoms be provided with significant dynamic range to achieve optimum adhesion.

Many types of metals can be deposited on the organic substrates including, for example, Ni, Cu, Ti, Cr, Al, Mo W, Rh, Pt and Pd. The substrates are organic materials including plastics, polyimide, polyesters, Teflon (a trademark of E I duPont deNemours), Mylar (also a trademark of E I duPont deNemours), and epoxies. Typically, the substrates are organic polymers. The reactive ion species which can be used include many different ions, such as F, Cl, S, O, N, $CF_4$, $CCl_4$, CO and H.

Substrate irradiation and metal deposition can occur over a range of temperatures, including room temperature and elevated temperatures. Commercially available ion sources can be used to provide low energy ion beams, and the metal deposition step is also a dry processing step, such as sputtering or evaporation.

How the invention can be carried out will now be described by way of example, with reference to the accompanying drawings, in which:-

Figure 1 schematically illustrates an apparatus for carrying out the present invention; and
Figure 2 is a spectrum of a polyimide surface produced by ultraviolet photoemission spectroscopy, which indicates the change in surface chemistry of the polyimide after irradiation by low energy reactive ions in accordance with the present invention.

In putting this invention into practice, low energy beams are used to alter the surface chemistry of a thin layer at the surface of the organic substrate onto which metal is to be deposited. The particles which can be used to irradiate the organic substrate are reactive ions, electrons, and photons, having energies in the appropriate range. For example, the reactive ions and electrons have energies in the range 50 to 2000 eV, with preferred particle energies being in the range 200 to 500 eV. The energy range suitable for photons is about 0.2 eV to 500 eV, with the preferred range being 0.5 to 10 eV. Infrared radiation will provide photons having energies of about 0.2 eV and greater, while ultraviolet radiation will provide photons having energies of about 2 to 10eV. In the practice of this invention, the surface chemistry of the organic substrate is modified to a depth of about 1 to 30 nm. Low energy particle irradiation of the substrate can occur prior to or during metal deposition.

During the low energy particle bombardment, chemical bonds in the organic substrate are broken and altered and/or the surface of the substrate is heated. Parameters important for adhesion, such as the rate of metal deposition, are closely correlated to the rate of arrival of the low energy particles in order to adjust the relative impingement rates to achieve optimum adhesion. The dominant mechanism for enhancing adhesion is a chemical one in which the chemical activity of the surface layer of the substrate is altered by the low energy particle irradiation. Any physical rearrangement of atoms and molecules in the substrate occurs only to a very small degree, and is not a significant mechanism in producing enhanced adhesion.

It is the initial deposition of the metal onto the substrate which is important for adhesion. Once approximately 30 nm of continuous metal film are formed on the surface of the substrate, the metal deposition rates can be increased without affecting metal substrate adhesion. Typically, the metal is initially deposited at rates of from 0.1 to 10 nm/sec, corresponding to $10^{15}$ to $10^{17}$ atoms/cm²-sec. The particle flux of the incident reactive ions, electrons, or photons, in the radiation beam are of this order to provide enhanced metal-substrate adhesion.

Particle irradiation can occur at room temperature, or at elevated substrate temperatures. For significantly enhanced metal-substrate adhesion, the teachings of co-pending European application number 86300070.9 can be incorporated to provide optimum substrate temperatures. Further, the angle of incidence of the low energy particles is not critical, except that very shallow grazing angles (less than about 10 to 20°) will not have a significant effect on the chemistry of the surface layer of the substrate within reasonable periods of time. For angles with incidence greater than grazing angles, and especially with the common practice of using near normal incidence, substrate irradiation with low energy reactive ions, electrons, or photons can occur over time periods ranging from minutes to serveral hours in order to chemically activate the substrate.

At least two modes of operation can be undertaken. In the first, the substrate surface is irradiated with reactive ions, electrons, or photons to alter the surface chemistry in the substrate. After irradiation with these low energy particles for a sufficient period of time to provide surface chemistry alteration to a depth in the substrate of about 30 nm or less, the irradiation is stopped. After this, the metal film is deposited using a dry process such as evaporation or sputtering. Deposition of the metal can occur in the same vacuum chamber as that in which the low energy particle irradiation occurs, in order to minimise contamination and to achieve the total in-situ processing.

In a second mode of operation, low energy particle irradiation occurs slightly prior to (optional) and during metal deposition. In this process, the incident reactive ions, electrons, or photons have the same effect as in the first mode of operation, that is, they modify the surface chemistry of the organic substrate. In order to optimise adhesion in this second mode of operation, the energy beam must combine properly with the metallisation beam and for this reason the arrival rates of the low energy particles are comparable (i.e within one or two orders of magnitude) to the arrival rates of the metal atoms. THis is easily accomplished with a controlled ion beam source, an electron beam source or a photon source. For example, for initial metal deposition rates of 0.1 to 10nm/sec, $10^{15}$-$10^{17}$ atoms/cm²-sec, are corresponding particle fluxes.

Accurate control of the low energy particle fluxes in relation to the metal deposition rate for the initial phases of metal deposition is extremely important, as emphasised in the previous paragraph. As a follow-on to an earlier discussion, such control of fluxes cannot be obtained using plasma or glow discharge systems for energy beam impingement of a substrate. Those systems require high pressures of the order of 133 Pascals (1 torr), which corresponds to about $10^{21}$ gas atoms/cm²-sec, in order to maintain the discharge. These rates will dominate all other rates in the system. Furthermore, these rates cannot be matched with metal evaporation rates which must be fairly slow during the initial formation of the metal layer on the substrate. Also, metal evaporation cannot be carried out at such high pressures.

Any type of metal can be deposited by sputtering or evaporation in-situ after or during low energy impingement of the organic substrate. In the practice of this invention, the low energy particles are either reactive ions, electrons or photons. The organic substrates include all types of polymer materials, including plastic, epoxies, polyimide, polyesters, Teflon and Mylar. These organic materials can be layered onto glasses, semiconductors, ceramics, or insulators. Further, the substrate can be made up of laminations of polymer-type materials.

The low energy particles suitable for altering the surface chemistry of the organic substrate in accordance with the present invention include all types of reactive ions, as well as electrons and photons. Suitable examples of reactive ions include O, N, Cl, $CF_4$, $CCl_4$, CO, H, F and S. In general, the low energy particles are those which will react with the material of the substrate to produce chemical changes in the first few tens of nanometers of the substrate.

The adhesion of any metal to the organic substrate is enhanced by the practice of this invention. However the enhancement of adhesion will vary in degree with the metal and substrate combination that is chosen. For example, the adhesion of Cu on polyimide is significantly enhanced by reactive oxygen or nitrogen treatment of the polyimide, improving adhesion by a factor of 10 or more. In another example, reactive ion treatment of polyimide improves the adhesion of Cr thereto, and also minimises stress between the Cr and the polyimide. This also aids adhesion and yields a Cr-polyimide structure having a significantly greater peel strength.

It appears that the chemistry of the organic substrate is modified sufficiently that metastable compounds can be formed in the surface of the substrate when the metal atoms impinge on the substrate. These metastable compounds are not those which can be formed by simple heating, as by annealing the substrate. This change in the chemistry of the metal-substrate interface improves adhesion and lessens stress between the deposited metal film and the substrate, perhaps by controlling the microstructure of the metal-substrate interface.

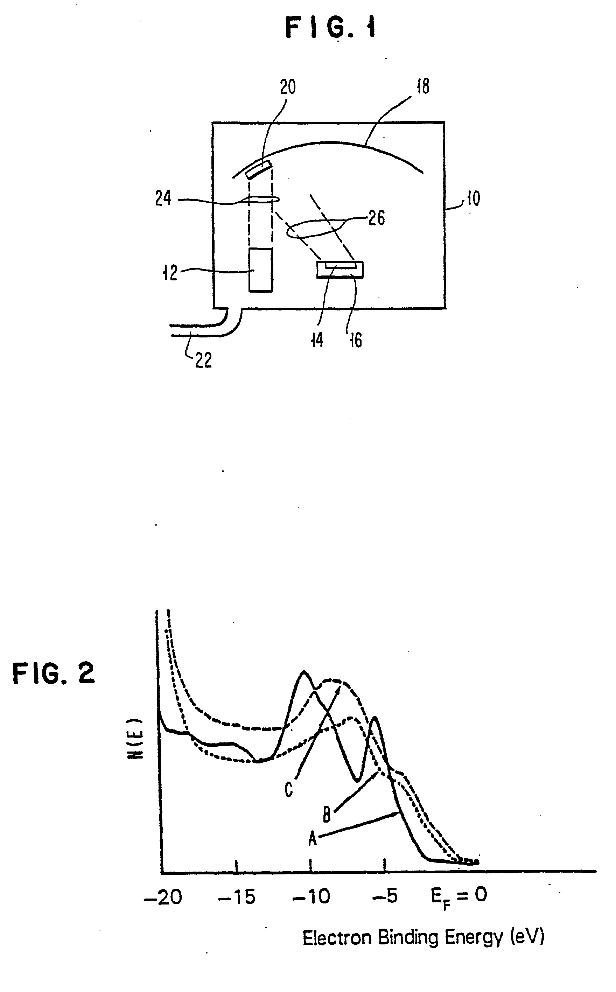

Figure 1 schematically illustrates an apparatus which is suitable to practice the present invention. The apparatus includes a vacuum chamber 10 in which is located an ion source 12 and an evaporant source 14, placed in a holder 16. A substrate holder 18 supports a substrate 20. Output port 22 can be connected to a vacuum pump (not shown) in order to adjust the pressure within chamber 10. Although it is not shown in detail, the ion source would include an input port for providing gases, such as oxygen and nitrogen, to the ion source. Ion beam sources are well known in the art and a suitable one is a Kaufman-type ion source such as those described in US-A-4,259,145 and by H R Kaufman et al, J Vac Sci Tech 21(3), page 925, September/October 1982. This type of source provides a uniform flux of ions over a large area, and can be easily controlled to provide low energy ions having energies in the range of about 50 to 2000 eV.

In Figure 1, the dashed lines 24 indicate the ions which are directed to the substrate 20, while the dashed lines 26 indicate the vapourised metal which deposits upon substrate 20.

In practice, the required gases are introduced through a typical metering system into the ion source 12 at the required flow rate for sustaining a discharge in the ion source. Once the discharge is established, the ion beam is energised at a low energy, 50 to 2000 eV. These ions are accelerated to the substrate in order to modify its surface chemistry. Either simultaneously with the ion beam or after ion treatment of the substrate, metal can be deposited.

The apparatus of Figure 1 can be modified slightly if electrons or photons are used to change the surface chemistry of the substrate. Any type of photon source with the proper energy range, such as a laser or a flash lamp, can be used although lasers are preferred. The electron source can be a commercially available source where the electron source is located in the vacuum chamber. Thus, the source 12, in its broadest sense, represents a reactive ion source, a photon source, or an electron source.

Figure 2 illustrates the effect of the low energy particle irradiation on the organic substrate. In this figure, photoemission spectroscopy is used to show the spectrum of photoemitted electrons N(E) as plotted against the electron binding energy (eV). Three different curves A, B, and C are shown. Curve A illustrates the spectrum obtained from a polyimide film which has been annealed, but untreated by reactive ions. Curve B illustrates the change in surface chemistry of the polyimide film when it has been irradiated by reactive oxygen ions. Curve C indicates the effect of post-annealing on the oxygen ion irradiated polyimide, and indicates that the post-annealing step shifts the energy spectrum so that it is more similar to the original spectrum (A).

Figure 2 indicates the number of electrons N(E) emitted from the polyimide due to the incidence of photons having an energy of 40.8 eV and shows a significantly different spectrum in curve B. This spectrum indicates the change in surface chemistry of a shallow surface layer of the polyimide, indicating that reactive oxygen ion bombardment has altered the surface chemistry of the polymide. It is this alteration of the surface chemistry which leads to increased adhesion and reduced stress in metals deposited on the polyimide.

The following examples will demonstrate the use of low energy reactive ions, electrons or photons to improve metal-substrate adhesion.

EXAMPLE 1

The adhesion between copper films and polyimide was increased by bombarding a polyimide surface with a low energy oxygen or nitrogen ion beam prior to deposition of copper. Adhesion improved by a factor of 10 or more. The deposition and ion treatment were performed in an electron beam evaporator having a Kaufman-type ion beam source installed inside the processing chamber. This allowed in-situ bombardment followed by copper deposition onto the treated polyimide surface, where the substrate always remained within the processing chamber. Nitrogen and oxygen were introduced through a metering system into the ion source at the required flow rate for sustaining a glow discharge. Once the discharge is established the beam is energised at a low energy, in this example at 50 to 500 eV. The ions were accelerated to the substrate coated with polyimide for a sufficient amount of time to allow thorough treatment of the polyimide. This can range from minutes to a couple of hours. Once the surface was modified, the copper was deposited.

Conventional peel testing was undertaken on a tensile strength tester, yielding the following minimum values:

Adhesion of Cu to polyimide (untreated) - 3 g/mm
Adhesion of Cu to polyimide (O$_2$ ion treated) $\geq$ 35 g/mm
Adhesion of Cu to polyimide (N$_2$ ion treated) $\geq$ 30 g/mm

EXAMPLE 2

Copper was again deposited on polyimide. The polyimide was spun onto an aluminium-covered silicon wafer. Reactive nitrogen and oxygen ion bombardment was carried out in-situ prior to the copper deposition using a standard sputter ion gun at 250 eV in an oxygen or nitrogen partial pressure of 0.027 to 0.04 Pascals (2 to 3 $\times$ 10$^{-4}$ torr). The ion beam current density was of the order of a microamp/cm$^2$ for one hour. After this treatment, a copper layer 8 $\mu$m thick was deposited onto the treated polyimide surface.

Surface analysis prior to copper deposition showed that the reactive ion bombardment changed the composition of the polyimide surface. X-ray photoemission spectroscopy revealed that nitrogen or oxygen incorporated into the polyimide by ion bombardment was in a different chemical state than the corresponding atomic species already present in the untreated polyimide. Ultraviolet photoemission spectroscopy also showed valence state chemical bonding changes. These observations, as well as the absence of adhesion improvement for inert gas ion (Ar) bombardment, demonstrated that the enhanced adhesion is a result of chemical activation of the polyimide surface.

EXAMPLE 3

The following table shows the results of various pre-treatment steps in the preparation of polyimide substrates. All pre-treatment steps occurred at room temperature. At higher temperatures, the adhesion increased. From the table, it is apparent that oxygen ion and nitrogen ion pre-treatments of polyimide significantly improve the adhesion, while other pre-treatment steps, such as argon ion bombardment and KOH etching, do not significantly improve adhesion.

## TABLE

| Sample | Pre-Treatment | Composition | | | Adhesion/Strength | |
|---|---|---|---|---|---|---|
| | | C : | N : | O | g/mm | |
| 1 | As prepared | 8.2 | 1.0 | 1.7 | None | |
| 2 | Argon-sputtering | 19.2 | 1.0 | 0.9 | None | |
| 3 | KOH-Etching | 23.2 | 1.0 | 6.6 | 0.211 | 0.238 |
| 4 | O - Sputtering | 9.3 | 1.0 | 1.2 | 1.27 | 1.41 |
| 5 | N - Sputtering | 5.3 | 1.0 | 0.6 | 1.63 | 1.09 |

In the practice of this invention, low energy reactive ions, electrons, and photons are used to alter the surface chemistry of a thin layer of an organic substrate in order to promote increased adhesion between the substrate and a metal layer deposited thereon. It is important that the energy of the incident particles (reactive ions, electrons, and photons) be less than about 2000 eV, and that the incident particles are those which will alter the surface chemistry of a thin surface region of the substrate. This chemistry is altered to a depth of approximately 30 nm or less. Still further, if the particle treatment occurs simultaneously with the metal deposition, the arrival rates of the metal atoms and the reactive ions, electrons, or photons must be within about one or two orders of magnitude of each other so that maximum chemical alteration and mixing can occur at the metal-substrate interface. Until a continuous film of metal is established on the surface of the substrate, metal atom arrival rates are chosen to be less than about 10 nm/sec.

## Claims

1. A method of metallising an organic substrate so as to achieve improved adhesion of the metal, comprising irradiating a surface of the substrate with low energy particles, said particles being either
(a) reactive ions or electrons having energies in the range of about 50 to 2000 eV; or
(b) photons having energies in the range of about 0.2 to 500 eV,
the surface being subjected to said irradiation until the chemical composition of the substrate is altered due to said irradiation to a depth of approximately 1 to 30 nm from said surface,
and depositing metal onto the irradiated surface at an initial rate of approximately 0.1 to 10 nm per second.

2. A method as claimed in claim 1, in which the metal is deposited by vacuum deposition or sputtering.

3. A method as claimed in claim or claim 2, in which the metal is deposited at room temperature.

4. A method as claimed in claim 1 or claim 2, in which the substrate is a polymer and in which the metal is deposited at a temperature greater than room temperature but less than the curing temperature of the polymer.

5. A method as claimed in claim 4, in which the substrate consists of polymide, polyester, Mylar, Teflon or epoxy.

6. A method as claimed in any preceding claim, in which the irradiation occurs prior to the deposition of the metal.

7. A method as claimed in any of claims 1 to 5, in which the irradiation and the metal deposition occur simultaneously at least until a continuous metal film is formed on said substrate surface, the rates of arrival at said substrate surface of said low energy particles and atoms of said metal being within approximately 2 orders of magnitude of one another.

8. A method as claimed in any preceding claim, in which the irradiation occurs with a particle flux of about $10^{15}$-$10^{17}$ particles/cm$^2$-sec.

9. A method as claimed in any preceding claim, in which the irradiation is with reactive ions or electrons having energies in the range of about 200 to 500 eV.

10. A method as claimed in any of claims 1 to 8, in which the irradiation is with photons having energies in the range of about 0.5 to 10 eV.

11. A method as claimed in any preceding claim, in which the metal consists of Ni, Cu, Ti, Al, Cr, Mo, W, Rh, Pt or Pd.

12. A method as claimed in claim 11, in which the irradiation is with ions of O, N. S, F, Cl, CF$_4$, CCl$_4$, CO, or H.

13. A method as claimed in any preceding claim, in which the substrate consists of polyimide, the substrate surface is irradiated with low energy oxygen or nitrogen ions and copper is deposited on the irradiated substrate surface.

## Patentansprüche

1. Verfahren zur Metallisierung eines organischen Substrats, um eine verbesserte Verbundwirkung des Metalls zu erreichen, enthaltend die Bestrahlung einer Oberfläche des Substrats mit niederenergetischen Teilchen, wobei die genannten Teilchen entweder

(a) reaktive Ionen oder Elektronen sind, die Energien in dem Bereich von ungefähr 50 bis 2000 eV aufweisen, oder

(b) Photonen sind, die Energien im Bereich von ungefähr 0,2 bis 500 eV aufweisen,

wobei die Oberfläche der genannten Bestrahlung unterworfen wird, bis die chemische Zusammensetzung des Substrats, bedingt durch die genannte Bestrahlung, bis zu einer Tiefe von ungefähr 1 bis 30 nm von der genannten Oberfläche verändert wird,

und wobei das Metall nur auf der bestrahlten Oberfläche mit einer Anfangsgeschwindigkeit von ungefähr 0,1 bis 10 nm pro Sekunde abgeschieden wird.

2. Verfahren nach Anspruch 1, in welchem das Metall durch Vakuumablagerung oder Kathodenzerstäubung abgeschieden wird.

3. Verfahren nach Anspruch 1 oder 2, in welchem das Metall bei Raumtemperatur abgeschieden wird.

4. Verfahren nach Anspruch 1 oder 2, in welchem das Substrat ein Polymer ist und in welchem das Metall bei einer Temperatur abgeschieden wird, die grösser ist als die Raumtemperatur aber kleiner als die Aushärtungstemperatur des Polymers.

5. Verfahren nach Anspruch 4, in welchem das Substrat aus Polyimid, Polyester, Mylar, Teflon oder Epoxy besteht.

6. Verfahren nach einem der vorangehenden Ansprüche, in welchem die Bestrahlung vor der Metallabscheidung stattfindet.

7. Verfahren nach einem der Ansprüche 1 bis 5, in welchem die Bestrahlung und die Metallabscheidung gleichzeitig erfolgen, zumindest bis sich ein kontinuierlicher Metallfilm auf der genannten Substratoberfläche gebildet hat, wobei die Geschwindigkeiten des Erscheinens auf der genannten Substratoberfläche der genannten niederenergetischen Teilchen und Atome des genannten Metalls innerhalb ungefähr 2 Grössenordnungen voneinander liegen.

8. Verfahren nach einem der vorangehenden Ansprüche, in welchem die Bestrahlung mit einem Teilchenfluss von ungefähr $10^{15}$-$10^{17}$ Teilchen/cm$^2$/s erfolgt.

9. Verfahren nach einem der vorangehenden Ansprüche, in welchem die Bestrahlung mit reaktiven Ionen oder Elektronen erfolgt, welche Energien im Bereich von ungefähr 200 bis 500 eV aufweisen.

10. Verfahren nach einem der Ansprüche 1 bis 8, in welchem die Bestrahlung mit Photonen erfolgt, welche Energien im Bereich von ungefähr 0,5 bis 10 eV aufweisen.

11. Verfahren nach einem der vorangehenden Ansprüche, in welchem das Metall aus Ni, Cu, Ti, Al, Cr, Mo, W, Rh, Pt oder Pd besteht.

12. Verfahren nach Anspruch 11, in welchem die Bestrahlung mit Ionen von O, N, S, F, Cl, CF$_4$, CCl$_4$, CO oder H erfolgt.

13. Verfahren nach einem der vorangehenden Ansprüche, in welchem das Substrat aus Polyimid besteht, die Substratoberfläche mit niederenergetischen Sauerstoff- oder Stickstoffionen bestrahlt wird und Kupfer auf der bestrahlten Substratoberfläche abgeschieden wird.

**Revendications**

1. Procédé pour la métallisation d'un substrat organique permettant d'obtenir une adhésion améliorée du métal, caractérisé en ce qu'il comprend l'irradiation d'une surface du substrat par des particules de faible énergie, ces particules étant soit:

(a) des ions réactifs ou des électrons ayant des énergies dans la gamme d'environ 50 à 2000 eV, soit

(b) des photons ayant des énergies dans la gamme d'environ 0,2 à 500 eV.

la surface étant soumise à cette irradiation jusqu'au moment où la composition chimique du substrat est modifiée sous l'effet de cette irradiation sur une profondeur d'environ 1 à 30 nm à partir de la surface, et le dépôt d'un métal sur la surface irradiée à une vitesse initiale d'environ 0,1 à 10 nm par seconde.

2. Procédé suivant la revendication 1, caractérisé en ce que le métal est déposé par dépôt sous vide ou par pulvérisation.

3. Procédé suivant la revendication 1 ou la revendication 2, caractérisé en ce que le métal est déposé à la température ambiante.

4. Procédé suivant la revendication 1 ou la revendication 2, carctérisé en ce que le substrat est un polymère et le métal est déposé à une température supérieure à la température ambiante mais inférieure à la température de durcissement du polymère.

5. Procédé suivant la revendication 4, caractérisé en ce que le substrat est un polyimide, un polyester, du Mylar, du Téflon ou un époxy.

6. Procédé suivant l'une quelconque des revendications précédentes, caractérisé en ce que l'irradiation a lieu avant le dépôt du métal.

7. Procédé suivant l'une quelconque des revendications 1 à 5, caractérisé en ce que l'irradiation et le dépôt de métal ont lieu simultanément au moins jusqu'à formation d'un film métallique continu sur cette surface de substrat, les vitesses d'arrivée sur la surface du substrat de ces particules de faible énergie et des atomes de métal étant à environ à 2 ordres de grandeur près les unes des autres.

8. Procédé suivant l'une quelconque des revendications précédentes, caractérisé en ce que l'irradiation a lieu avec un flux de particules d'environ $10^{15}$–$10^{17}$ particules/cm$^2$.seconde.

9. Procédé suivant l'une quelconque des revendications précédentes, caractérisé en ce que l'irradiation est effectuée avec des ions réactifs ou des électrons ayant des énergies dans la gamme d'environ 200 à 500 eV.

10. Procédé suivant l'une quelconque des revendications 1 à 8, caractérisé en ce que l'irradiation est effectuée avec des photons ayant des énergies dans la gamme d'environ 0,5 à 10 eV.

11. Procédé suivant l'une quelconque des revendications précédentes, caractérisé en ce que le métal consiste en Ni, Cu, Ti, Al, Cr, Mo, W, Rh, Pt ou Pd.

12. Procédé suivant la revendication 11, caractérisé en ce que l'irradiation est effectuée avec des ions de O, N, S, F, Cl, $CF_4$, $CCl_4$, CO ou H.

13. Procédé suivant l'une quelconque des revendications précédentes, caractérisé en ce que le substrat consiste en polyimide, la surface du substrat est irradiée par des ions oxygène ou azote de faible énergie et du cuivre est déposé sur la surface du substrat irradiée.

# FIG. 1

# FIG. 2

Electron Binding Energy (eV)